# EUROPÄISCHE PATENTSCHRIFT

(11) **EP 3 058 112 B1**
(45) Veröffentlichungstag und Bekanntmachung des Hinweises auf die Patenterteilung: **04.10.2017**
(21) Anmeldenummer: 14789538.7
(22) Anmeldetag: 09.10.2014
(51) Int. Cl.: C23C 4/134, C23C 4/08, C23C 4/02, H05K 1/02, H05K 1/03, H05K 3/00, B29C 70/02, B29K 101/12, B29K 507/02

(54) **HERSTELLUNGSVERFAHREN FÜR EINEN PLASMABESCHICHTETEN FORMKÖRPER UND BAUTEIL**
METHOD OF MANUFACTURING A PLASMA COATED SHAPED BODY AND COMPONENT
PROCÉDÉ DE MANUFACTURE D'UNE PIÈCE FORMÉE REVÊTUE PAR PLASMA ET COMPOSANT

(30) Priorität: 14.10.2013 DE 102013111306
(43) Veröffentlichungstag der Anmeldung: 24.08.2016
(73) Patentinhaber: Plasma Innovations GmbH, 4800 Attnang-Puchheim (AT); Ensinger GmbH, 71154 Nufringen (DE)
(72) Erfinder: BISGES, Michael, 93049 Regensburg (DE); HENNE, Christian, 71154 Nufringen (DE); WUCHTER, Matthias, 72770 Reutlingen (DE)
(74) Vertreter: Kohlmann, Kai
(86) Internationale Anmeldenummer: PCT/EP2014/071602
(87) Internationale Veröffentlichungsnummer: WO 2015/055486

(56) Entgegenhaltungen:
- EP-A1- 2 110 866
- EP-A1- 2 476 723
- EP-A1- 2 631 332
- US-A- 6 048 919
- US-A1- 2012 134 631
- FELDMANN K ET AL: "Aktuelle Werkstoffe und Herstellungsverfahren: Technologie 3D-MID", KUNSTSTOFFE INTERNATIONAL, Bd. 94, Nr. 4, 2004, Seiten 17-24, XP008032245, Carl Hanser Verlag, München [DE] ISSN: 0945-0084

## Beschreibung

Die Erfindung betrifft eine Verfahren zum Herstellen eines Formkörpers mit einem Beschichtungsmaterial sowie ein Bauteil mit einem derartigen Formkörper.

Es ist bekannt, ein atmosphärisches Plasma, auch als Niedertemperaturplasma bezeichnet, zu nutzen, um Schichten auf Substraten abzuscheiden.

Aus der EP 1 230 414 B1 ist ein Verfahren zum Aufbringen einer Beschichtung auf einem Substrat bekannt, bei dem durch Hindurchleiten eines Arbeitsgases durch eine Anregungszone ein Plasmastrahl eines Niedertemperaturplasmas unter atmosphärischen Bedingungen erzeugt wird. In den Plasmastrahl wird getrennt von dem Arbeitsgas ein Beschichtungsmaterial eingespeist.

Aus der EP 1 675 971 B1 ist ein weiteres Verfahren zur Beschichtung einer Substratoberfläche unter Verwendung eines Plasmastrahls eines Niedertemperaturplasmas bekannt, dem ein feinkörniges, die Beschichtung bildendes Pulver zugeführt wird.

Abweichend von den thermischen Plasmen erreicht die Temperatur eines Niedertemperaturplasmas im Kern des Plasmastrahls bei Umgebungsdruck weniger als 900 Grad Celsius.

Für thermische Plasmen werden in der EP 1 675 971 B1 indes Temperaturen im Kern des auftretenden Plasmastrahls von bis zu 20.000 Grad Celsius angegeben.

Die atmosphärische Plasmabeschichtung von Trägermaterialien aus Kunststoffen mittels eines Niedertemperaturplasmas mit unterschiedlichsten Beschichtungsmaterialien, wie z.B. Metallen, Glas, Polymeren, Keramiken ist problematisch. Als Trägermaterialien werden reine Kunststoffe, wie z.B. Polycarbonat, Polypropylen oder Polyamid verwendet. Zwischen dem Träger- und Beschichtungsmaterial treten jedoch häufig Haftungsprobleme auf. Additive aus dem Kunststoff oder das Polymer selber degradieren während der atmosphärischen Plasmabeschichtung. Die niedermolekularen Bestandteile führen zu einer Ablösung der Beschichtung, die teilweise unmittelbar nach der Beschichtung, teilweise erst nach einer Alterung beobachtet werden kann.

Ferner ist aus der JP 2004217848 A ein Herstellungsverfahren für ein schlauchförmiges Bauteil eines elektrophotographischen Apparates bekannt. Das Bauteil besteht aus Polyimidharz sowie 10 - 70 Gewichtsprozent eines anorganischen Pulvers, um die Wärmeleitfähigkeit des Bauteils zu erhöhen. Um Toner besser von der Oberfläche des Bauteils entfernen zu können, wird die Oberflächenenergie des Bauteils durch eine atmosphärische Plasmabehandlung mit einer Flourverbindung reduziert.

Aus der EP 2 2236 645 A1 ist ein Verfahren zum Erhöhen der Durchschlagfestigkeit eines Polymers, insbesondere für einen Folienkondensator bekannt, bei dem die Oberfläche des Polymers einer Plasmabehandlung mit einem Gas in einer Reaktionskammer in einem Unterdruckbereich zwischen 13,3 mPa und 2 kPa (0,1 milliTorr und 15 Torr) ausgesetzt wird. Das Gas stammt aus der Gruppe umfassend Sauerstoff, Ozon, Kohlenstofftetrafluorid, Stickstoff, Luft, Ammoniak, Wasserstoff, Argon, Distickstoffoxid, Schwefelhexafluorid, Chlor, BCl 3 und Helium. Um die Wärmeleitfähigkeit des Polymers zu verbessern, ist das Polymer in einer Ausführungsform des Verfahrens ein Polymer-Verbundwerkstoff, wobei dem Polymer-Verbundwerkstoff in einer Menge von etwa 1 Gewichtsprozent bis etwa 80 Gewichtsprozent bezogen auf das Gesamtgewicht des Verbundwerkstoffs ein anorganischer Bestandteil, z. B. ein Füllmaterial hinzugefügt wird. US 2012/134631 A offenbart einen spritzgegossenen Schaltungsträger (molded interconnect device; "MID") als Formkörper aus einem Trägermaterial, welches ein thermoplastischer Kunststoff sein kann und welches thermisch leitfähige Bestandteile enthält, wobei unter anderem Bornitrid genannt wird. Auf dieses Trägermaterial wird eine metallische Schicht aufgebracht, wobei die Abscheidung durch chemische Prozesse erfolgt. Ausgehend von den bekannten Beschichtungsverfahren mittels Plasma besteht die Aufgabe darin, ein Verfahren der eingangs genannten Art zu schaffen, das eine dauerhafte Beschichtung von Formkörpern mittels atmosphärischen Plasmas erlaubt. Insbesondere soll die Abscheidung von Schichtdicken im Bereich von 0,001 bis 1000µm möglich sein. Schließlich soll die preisgünstige Herstellung unterschiedlicher Bauteile ermöglicht werden.

Diese Aufgabe wird durch ein Verfahren mit den Merkmalen des Anspruchs 1 und ein Bauteil mit den Merkmalen des Anspruchs 9 gelöst.

Die Lösung basiert unter anderem auf dem Gedanken, einen Formkörper aus einem speziellen Verbundstoff herzustellen, der anschließend zumindest teilweise mit dem metallischen Beschichtungsmaterial mittels atmosphärischem Plasma beschichtet wird. Als Verbundstoff (*engl. Compound*) werden Gemische aus sortenreinen Grundstoffen bezeichnet, denen zusätzliche Füllstoffe oder andere Additive beigemischt werden. Durch die Compoundierung werden mindestens zwei Stoffe miteinander zu einer homogenen Mischung verbunden.

Erfindungsgemäß ist vorgesehen, dass der Volumenanteil des Füllstoffs 1 - 50 % des Volumens des Formkörpers beträgt. Vorzugsweise beträgt der Volumenanteil des Füllstoffs zwischen 5 - 50 % des Volumens des Formkörpers. Aufgrund der homogenen Mischung von Füll- und Grundstoff in Verbindung mit dem Volumenanteil des Füllstoffs ist gewährleistet, dass die Füllstoffe sich auch im Bereich der Oberfläche des Formkörpers befinden. Die anorganischen Füllstoffe sind derart beschaffen, dass sie eine starke Haftung zu dem nachfolgend mittels atmosphärischen Plasmas aufgebrachten metallischen Beschichtungsmaterial aufbauen. Der Grundstoff besteht aus mindestens einem thermoplastischen Polymer.

Als Grundstoffe für den Verbundstoff kommen insbesondere in Betracht:
- Aliphatische Polyamide (bspw. PA66, PA6, PA12, PA11, PA610)
- Teilaromatische Polyamide (bspw. PA6T)
- Polyolefine (PE;PP)
- Thermoplastische Elastomere (bspw. TPE-A, TPE-E, TPE,O, TPE-U)
- Polyacetale (POM)
- Polyester (PET, PBT)
- Polycarbonate
- Polyacrylate (PMMA)
- Styrolkunststoffe (ABS)
- Polyarylensulfide (PPS)
- Polyaryetherketone (PEEK, PEK, PEKEKK)
- Polyarylsulfone (PSU, PE, PPSU)
- Fluorhaltige Polymere (PVDF)
- Flüssigkristalline Polymere (flüssigkristallines Polyester)
- Polyimide (PEI, PAI)

Besonders vorteilhaft für den nachfolgenden Beschichtungsschritt sind die nachfolgenden Grundstoffe:
- Aliphatische Polyamide (bspw. PA66, PA6, PA12, PA11, PA610)
- Teilaromatische Polyamide (bspw. PA6T)
- Polyester (PET, PBT)
- Polycarbonate
- Flüssigkristalline Polymere (flüssigkristallines Polyester)
- Styrolkunststoffe (ABS)
- Mischungen aus diesen Polymeren

Bornitrid wird als anorganischer Füllstoff verwendet. Bornitrid hat sich überraschend als haftungserhöhend für metallische Beschichtungen herausgestellt. Bornitrid weist üblicherweise Antihaft-Effekte gegenüber metallischen Schmelzen auf und wird im Wesentlichen als Trennmittel in der Metallgießerei verwendet. Bornitrid zeigt bei der atmosphärischen Plasmabeschichtung jedoch einen gegenteiligen Effekt, nämlich dass die metallische Beschichtung extrem hohe Haftkräfte zum Bornitrid als Füllstoff in dem Formkörper aufbaut. Hierdurch wird es möglich, den derart beschichteten Formkörper vorteilhaft für die massenhafte und preiswerte Herstellung insbesondere elektronischer Bauteile einzusetzen. Sofern nicht ausschließlich Bornitrid als Füllstoff zum Einsatz gelangt, beträgt der Volumenanteil des Bornitrids mindestens 50% des Volumenanteils des Füllstoffs, der vorzugsweise zwischen 5 - 50% des Volumens der Formkörpers beträgt. Sofern außer dem Bornitrid mindestens ein weiterer Füllstoff zum Einsatz gelangt, kommen als zusätzliche Füllstoffe für den Verbundstoff insbesondere in Betracht:
- Glasbasierte Füllstoffe (Glasfaser, Glaskugeln, Glashohlkugeln)
- Kohlenstoffbasierte Füllstoffe (Carbonfaser, Graphit, Ruß, CNT)
- Sulfate (Calciumsulfat, Bariumsulfat)
- Sulfide (Zinksulfid, Molybdändulfid, Wolframsulfid)
- Metallische Füllstoffe (Kupfer, Aluminium, Zinn, Zink, Edelstahl)
- Metalloxide (Magnetit)
- Mischungen aus diesen Füllstoffen

Besonders vorteilhaft für den nachfolgenden Beschichtungsschritt sind die nachfolgenden Füllstoffe:
- Mineralische Füllstoffe (Cristobalit, Quarzgut, Talkum, Glimmer, Kaolin, Wollastonit, Silikate (Bspw. Aluminiumsilikat, Feldspat, Nephelin, Basalit), Calciumcarbonat, Magnesiumcarbonat
- Keramische Füllstoffe (Bornitrid, Magnesiumoxid, Aluminiumoxid, Siliciumcarbid, Borcarbid, Titandiborid)

Der Beschichtungsprozess wird als atmosphärischer Plasma-Beschichtungsprozess ausgeführt. Dabei wird in einen Plasmaerzeuger ein metallisches Pulver eingeführt, das durch die Energiezufuhr aufschmilzt und sich als Beschichtungsmaterial als geschlossene Schicht auf dem Formkörper abscheidet. Um die bei dem Verfahren eingesetzten Grundstoffe nicht zu zerstören, kommen vorzugsweise Plasmaerzeuger zum Beschichten des Formkörpers mit einer Leistung im Bereich von 0,1 - 5 kW zum Einsatz. Bei dem atmosphärischen Plasmabeschichtungsprozess beträgt die Temperatur des Niedertemperaturplasmas im Kern des Plasmastrahls bei Umgebungsdruck vorzugsweise weniger als 900 Grad Celsius. Der atmosphärische Plasma-Beschichtungsprozess basiert auf einem Atmosphärendruckplasma (auch Normaldruckplasma), bei welchem der Druck ungefähr dem der umgebenden Atmosphäre - dem sogenannten Normaldruck - entspricht. Atmosphärendruckplasmen benötigen im Gegensatz zum Niederdruckplasma oder Hochdruckplasma kein Reaktionsgefäß, das für die Aufrechterhaltung eines zum Atmosphärendruck unterschiedlichen Druckniveaus oder abweichender Gasatmosphären für die Durchführung der Beschichtung sorgt.

Als metallische Beschichtungsmaterialien können in erster Linie reine Metalle, Legierungen oder Mischungen zum Einsatz kommen.

Sofern der Formkörper vor dem Verfahrensschritt des Beschichtens teilweise mit einer Antihaftbeschichtung versehen wird, wird in den mit der Antihaftbeschichtung, z.B. Lötstopplack, versehenen Bereichen des Formkörpers eine Anhaftung des metallischen Beschichtungsmaterials verhindert.

Hierdurch lässt sich die Genauigkeit des Beschichtungsprozess insbesondere in den Randbereichen der Beschichtung erhöhen. Insbesondere können durch gezieltes Auftragen der Antihaftbeschichtung komplexe und feingliedrige Beschichtungsstrukturen auf dem Formkörper abgeschieden werden.

In einer Ausgestaltung der Erfindung ist der Formkörper mit mindestens einem Trägerteil haftfest verbunden. Der Formkörper und/oder das mindestens eine Trägerteil kann im Spritzgussverfahren hergestellt werden. Vorzugsweise wird der Formkörper im Spritzgußverfahren dadurch hergestellt, dass das mindestens eine Trägerteil zumindest teilweise umspritzt wird.

Das erfindungsgemäße Verfahren ist im Zusammenhang mit der Herstellung von MID Bauteilen vorteilhaft einsetzbar. Als Molded Interconnect Devices (englisch für: Spritzgegossene Schaltungsträger), kurz MID, werden Bauteile bezeichnet, bei denen elektrische und mechanische Funktionen in ein Spritzgußteil integriert werden. Wesentliche Einsatzgebiete für die MID-Technik sind der Automobilbau, die Industrieautomatisierung, die Medizintechnik, die Hausgeräteindustrie, die Telekommunikationstechnik, die Mess- und Analysetechnik sowie die Luft- und Raumfahrt. Die Vorteile der MID-Technik liegen sowohl in der verbesserten Gestaltungsfreiheit und Umweltverträglichkeit, als auch in einem wirtschaftlichen Herstellungsprozess.

Bauteile umfassend einen nach dem erfindungsgemäßen Verfahren hergestellten Formkörper sind beispielsweise Antennen (Mobilfunk, WLAN, etc.) und LED Module mit integrierter Wärmesenke.

Durch den Einsatz eines Verbundstoffs lässt sich die Wärmeleitfähigkeit des Formkörpers deutlich verbessern, wodurch sich erfindungsgemäß hergestellte Formkörper vorteilhaft auch in Bauteilen einsetzen lässt, bei denen eine Ableitung von Wärmeenergie erforderlich ist.

Für die Ableitung von Wärmeenergie ist Bornitrid als Füllstoff des Verbundstoffs ebenfalls besonders gut geeignet, da der Formkörper eine hohe Wärmeleitfähigkeit bei gleichzeitig elektrisch isolierenden Eigenschaften aufweist. Ein Verbundstoff mit Bornitrid lässt sich ebenfalls im 2K-Spritzgußverfahren verarbeiten, indem ein Trägerteil mit hoher Wärmeleitfähigkeit und elektrischer Leitfähigkeit, beispielsweise aus einem mit Graphit gefüllten Material, mit dem Verbundstoff zumindest teilweise umspritzt wird. Der durch Umspritzen hergestellte Formköper deckt zumindest teilweise das Trägerteil ab. Die Leiterbahnstruktur wird auf dem Formkörper mit den elektrisch isolierenden Eigenschaften mittels atmosphärischen Plasmas abgeschieden.

Nachfolgend wird die Erfindung anhand der Figuren näher erläutert. Es zeigen:
- **Figur 1**: einen Formkörper aus einem Verbundstoff,
- **Figur 2**: den Formkörper nach Figur 1 mit einer Beschichtung,
- **Figur 3**: ein erstes Ausführungsbeispiel eines Bauteils umfassend einen Formkörper mit einem Beschichtungsmaterial,
- **Figur 4**: ein Anwendungsbeispiel des Bauteils nach Figur 3,
- **Figur 5**: ein zweites Ausführungsbeispiel eines Bauteils mit einem Formkörper mit einem Beschichtungsmaterial sowie
- **Figur 6**: einen Formkörper aus einem Verbundstoff an einem Trägerteil.

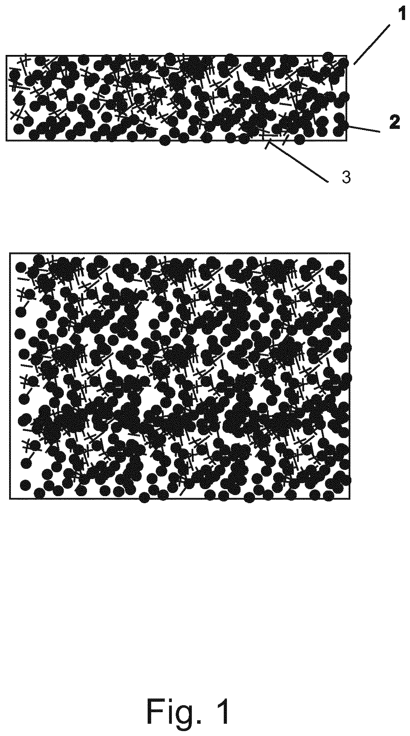

Figur 1 veranschaulicht den ersten Verfahrensschritt des erfindungsgemäßen Verfahrens. Zunächst wird ein Formkörper (1) aus einem Verbundstoff hergestellt. Der Verbundstoff umfasst als Grundstoff (3) ein thermoplastisches Polymer, dem in homogener Mischung ein Füllstoff (2) beigemischt wird. Der Volumenanteil des Füllstoffs (2) beträgt etwa 40 % des Volumens des Formkörpers (1), der in der oberen Bildhälfte in Seitenansicht und der unteren Bildhälfte in Aufsicht dargestellt ist. Aufgrund der homogenen Mischung des Füllstoffs (2) mit dem Grundstoff (3) ist in Verbindung mit dem Volumenanteil des Füllstoffs (2) gewährleistet, dass der Füllstoff (2) sich auch im Bereich der zu beschichtenden Oberfläche des Formkörpers (1) befindet, wie dies insbesondere aus der Aufsicht erkennbar ist.

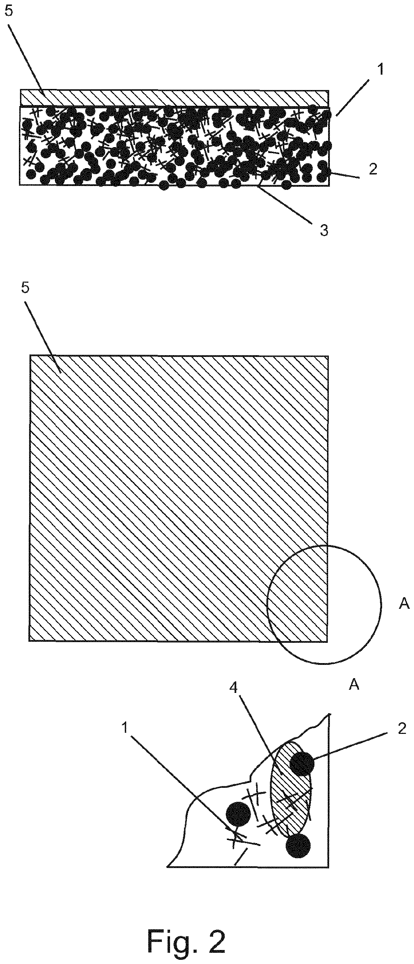

Der Füllstoff (2) weist eine starke Haftung zu einem mittels atmosphärischen Plasmas aufgebrachten, in Figur 2 dargestellten Beschichtungsmaterial (5) auf. In der in der oberen Bildhälfte von Figur 2 dargestellten Seitenansicht ist erkennbar, dass lediglich die nach oben weisende Oberfläche des Formkörpers (1) mit dem Beschichtungsmaterial (5) beschichtet wurde. Selbstverständlich liegt es im Rahmen der Erfindung, den gesamten Formkörper oder auch nur eine oder mehrere Teiloberflächen zu beschichten.

Die untere Bildhälfte von Figur 2 zeigt eine Aufsicht auf den Formkörper (1) mit dem Beschichtungsmaterial (5). Das Detail (A) in der Aufsicht verdeutlicht schematisch den Haftmechanismus des Beschichtungsmaterials (5) an dem Formkörper (1). Insbesondere ist erkennbar, wie einzelne Partikel (4) des Beschichtungsmaterials (5) teilweise den Füllstoff (2) sowie den Grundstoff (3) des Formkörpers (1) überdecken. Aufgrund der starken Haftung der Partikel (4) des Beschichtungsmaterials (5) zu dem Füllstoff (2) wird dauerhaft ein Ablösen des Beschichtungsmaterials (5) von dem Formkörper (1) verhindert.

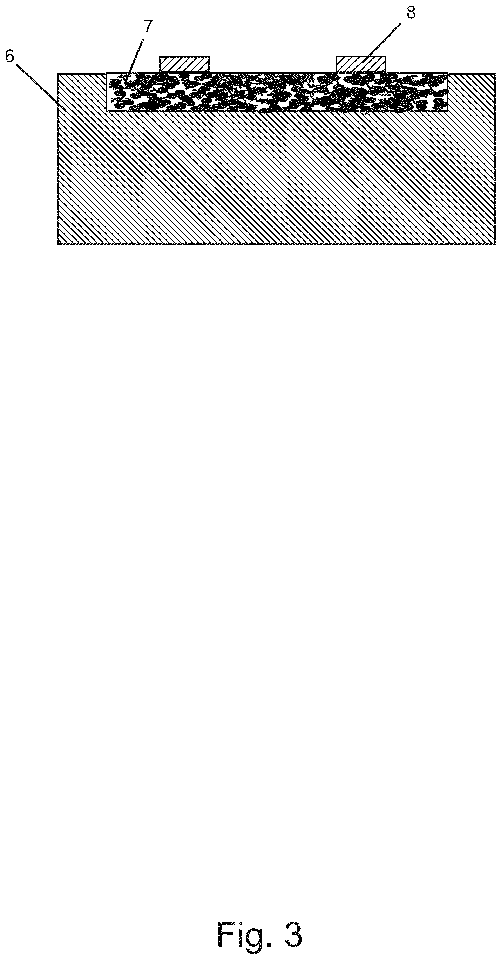

Figur 3 zeigt ein Bauteil, das im Zwei-Komponenten-Spritzgussverfahren hergestellt wird. Das Bauteil umfasst ein Trägerteil (6) mit hoher Wärmeleitfähigkeit und guter elektrischer Leitfähigkeit. Das Trägerteil (6) wird beispielsweise aus einem mit Graphit gefülltem Polymer gespritzt. Anschließend wird an das Trägerteil (6) der Verbundstoff angespritzt. Der durch Anspritzen hergestellte Formkörper (7) deckt das Trägerteil (6) an seiner Oberfläche teilweise ab. Der Formkörper (7) besteht aus einem thermoplastischen Polymer als Grundstoff (3) und einem anorganischen Füllstoff (2), wobei der Füllstoff (2) eine hohe Wärmeleitfähigkeit aufweist, jedoch elektrisch isolierend ist. Bei dem Füllstoff (2) des Formkörpers (7) handelt es sich um Bornitrid.

Zwei Teilbereiche der Oberfläche des Formkörpers (7) sind bei dem in Figur 3 dargestellten Bauteil mit metallischem Beschichtungsmaterial (5) mittels atmosphärischen Plasmas beschichtet. Bei dem metallischen Beschichtungsmaterial handelt es sich um ein elektrisch gut leitfähiges Metall, das auf der Oberfläche des gut Wärme leitenden, jedoch elektrisch isolierenden Formkörpers (7) elektrisch leitfähige Kontakte (8) ausbildet.

Das derart hergestellte Zwei-Komponenten-Spritzgussbauteil ist aufgrund der Eigenschaften des Verbundstoffs besonders geeignet, Wärme von einem an die Kontakte (8) angeschlossenen elektrischen Bauteil abzuleiten. Die elektrisch isolierenden Eigenschaften des Formkörpers (7) verhindern einen Kurzschluss zwischen den Kontakten (8). Die zugleich hohe Wärmeleitfähigkeit leitet die Wärme durch den Formkörper (7) in das darunter angeordnete Trägerteil (6) ab.

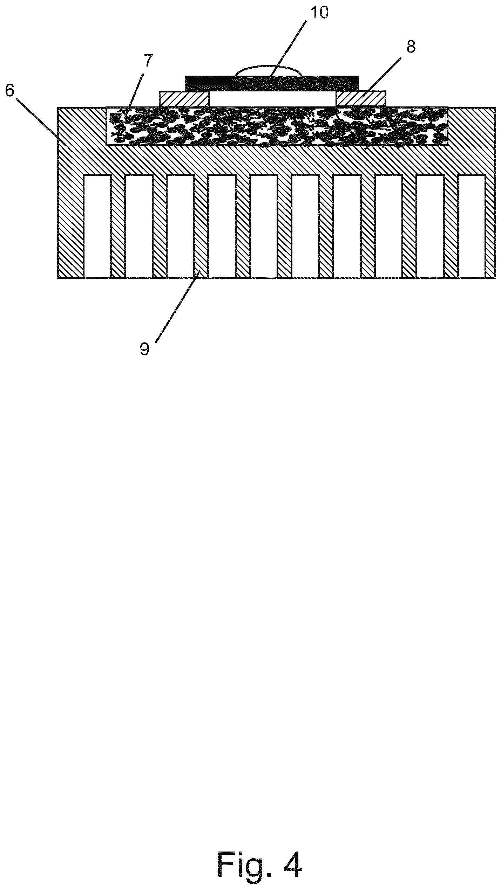

Figur 4 zeigt ein Anwendungsbeispiel des Bauteils nach Figur 3. Die Kontakte (8) stehen mit einem LED-Modul (10) in elektrisch leitfähiger Verbindung. Die von dem LED-Modul (10) entwickelte Wärme wird über den Formkörper (7) in das gut Wärme leitende Trägerteil (6) abgeleitet, das zusätzlich zur besseren Wärmeabfuhr an seiner Unterseite eine Vielzahl von Kühlrippen (9) aufweist, die den Wärmeaustausch des Trägerteils (6) mit der Umgebungsluft verbessern.

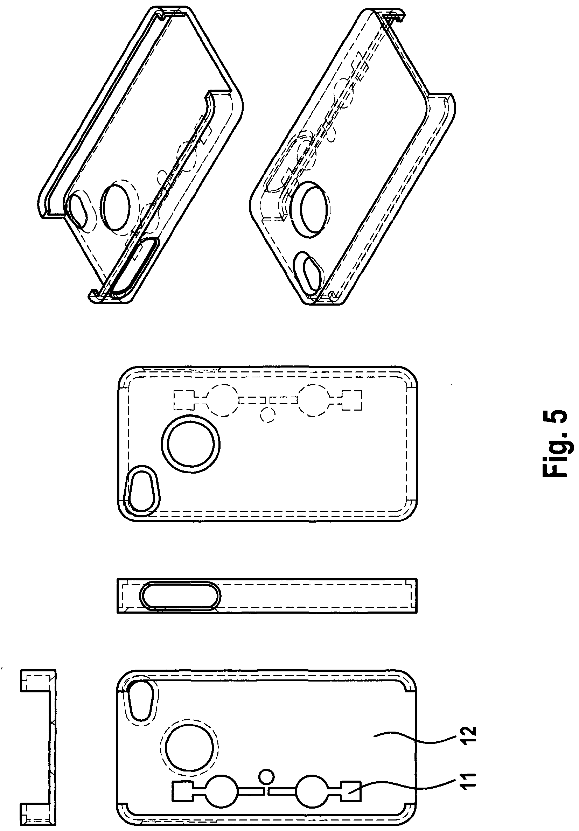

Figur 5 zeigt ein weiteres Bauteil umfassend einen Formkörper, der nach dem erfindungsgemäßen Verfahren hergestellt ist. Der Formkörper ist ein im Wege des Spritzgussverfahrens hergestellter Träger (12) aus dem Verbundstoff, auf dem eine Antennenstruktur (11) mittels atmosphärischen Plasmas abgeschieden wird.

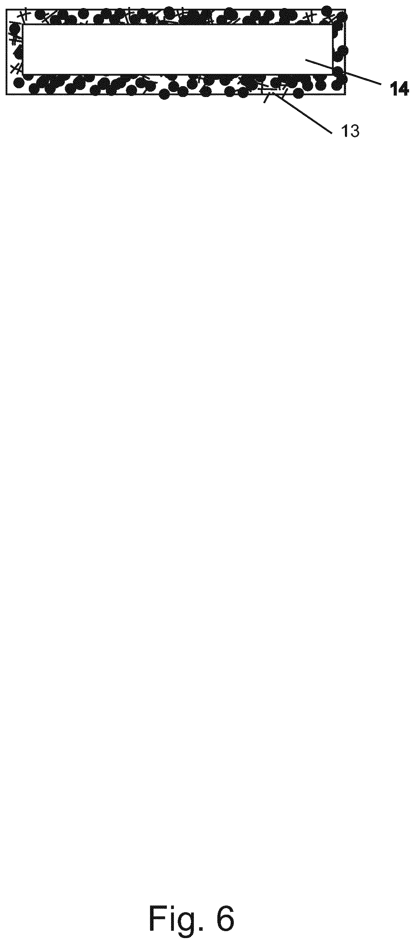

Figur 6 zeigt ein weiteres Spritzgussbauteil mit einem im Spritzgussverfahren hergestellten Trägerteil (14), das an vier Seiten von einem angespritzten Formkörper (13) umgeben wird. Das Beschichtungsmaterial ist der Übersichtlichkeit halber in Figur 6 nicht dargestellt.

**Bezugszeichenliste**

| **Nr.** | **Bezeichnung** |
|---|---|
| 1 | Formkörper |
| 2 | Füllstoff |
| 3 | Grundstoff |
| 4 | Partikel |
| 5 | Beschichtungsmaterial |
| 6 | Trägerteil |
| 7 | Formkörper |
| 8 | Kontakte |
| 9 | Kühlrippen |
| 10 | LED-Modul |
| 11 | Antennenstruktur |
| 12 | Formkörper |
| 13 | Formkörper |
| 14 | Trägerteil |

## Patentansprüche

1. Verfahren zum Herstellen eines Formkörpers (1,7,12,13) mit einem Beschichtungsmaterial (5) umfassend die Verfahrensschritte
- Herstellen eines Formkörpers (1,7,12,13) aus einem Verbundstoff, der mindestens ein thermoplastisches Polymer als Grundstoff (3) und zumindest Bornitrid als einen anorganischen Füllstoff (2) aufweist, wobei der Volumenanteil des Füllstoffs (2) 1 - 50 % des Volumens des Formkörpers (1,7,12,13) beträgt,
- Beschichten zumindest eines Teils des Formkörpers (1,7,12,13) mit einem metallischen Beschichtungsmaterial (5) mittels atmosphärischem Plasma.

2. Verfahren nach Anspruch 1, **dadurch gekennzeichnet, dass** der Formkörper mit mindestens einem Trägerteil haftfest verbunden wird.

3. Verfahren nach Anspruch 1 oder 2, **dadurch gekennzeichnet, dass** der Formkörper (7,13) oder das mindestens eine Trägerteil (6,14) im Spritzgußverfahren hergestellt wird.

4. Verfahren nach einem der Ansprüche 1 bis 3, **dadurch gekennzeichnet, dass** zum Herstellen des Formkörpers (1,7,12,13) ausschließlich Bornitrid als anorganischer Füllstoff verwendet wird.

5. Verfahren nach einem der Ansprüche 1 bis 3, **dadurch gekennzeichnet, dass** zum Herstellen des Formkörpers (1,7,12,13) zusätzlich zu dem Bornitrid mindestens ein anorganischer Füllstoff aus einer der nachfolgend genannten Füllstoffklassen verwendet wird:
Mineralische Füllstoffe, Keramische Füllstoffe, glasbasierte Füllstoffe, kohlenstoffbasierte Füllstoffe, Sulfate, Sulfide, metallische Füllstoffe oder Metalloxide.

6. Verfahren nach Anspruch 5, **dadurch gekennzeichnet, dass** der Volumenanteil des Bornitrids mindestens 50% des Volumenanteils des Füllstoffs beträgt.

7. Verfahren nach einem der Ansprüche 1 bis 6, **dadurch gekennzeichnet, dass** der Formkörper (1,7,12,13) vor dem Verfahrensschritt des Beschichtens teilweise mit einer Antihaft-Beschichtung versehen wird, die eine Anhaftung des metallischen Beschichtungsmaterials an dem Formkörper verhindert.

8. Verfahren nach einem der Ansprüche 2 bis 7, **dadurch gekennzeichnet, dass** der Formkörper (7,13) im Spritzgußverfahren dadurch hergestellt wird, dass das mindestens eine Trägerteil (6,14) zumindest teilweise umspritzt wird.

9. Bauteil umfassend einen Formkörper (1,7,12,13) mit einem Beschichtungsmaterial (5) herstellbar nach einem oder mehreren der Ansprüche 1 bis 8.

10. Bauteil nach Anspruch 9, **dadurch gekennzeichnet, dass** das Bauteil ein MID-Bauteil ist.

11. Bauteil nach Anspruch 9, **dadurch gekennzeichnet, dass** das Bauteil (6,7,8) ein Träger für LED Module (10) ist.

12. Bauteil nach Anspruch 9, **dadurch gekennzeichnet, dass** Bauteil den Formkörper (12) als Träger und die auf dem Formkörper (12) abgeschiedene Beschichtung (5) als Antennenstruktur (12) aufweist.

## Claims

1. Method for producing a moulded body (1, 7, 12, 13) with a coating material (5) comprising the process steps
- producing a moulded body (1, 7, 12, 13) from a composite material comprising at least one thermoplastic polymer as base material (3) and at least boron nitride as an inorganic filler (2), wherein the volume fraction of the filler (2) is 1-50% of the volume of the moulded body (1, 7, 12, 13),
- coating at least one part of the moulded body (1, 7, 12, 13) with a metal coating material (5) by means of atmospheric plasma.

2. The method according to claim 1, **characterized in that** the moulded body is connected to at least one carrier part in a firmly bonded manger.

3. The method according to claim 1 or 2, **characterized in that** the moulded body (7, 13) or the at least one carrier part (6, 14) is produced in the injection moulding method.

4. The method according to any one of claims 1 to 3, **characterized in that** in order to produce the moulded body (1, 7, 12, 13) exclusively boron nitride is used as inorganic filler.

5. The method according to any one of claims 1 to 3, **characterized in that** in order to produce the moulded body (1, 7, 12, 13) in addition to the boron nitride, at least one inorganic filler from the filler classes mentioned hereinafter is used:
mineral fillers, ceramic fillers, glass-based fillers, carbon-based fillers, sulphates, sulphides, metal fillers or metal oxides.

6. The method according to claim 5, **characterized in that** the volume fraction of boron nitride is at least 50% of the volume fraction of the filler.

7. The method according to any one of claims 1 to 6, **characterized in that** prior to the coating process step the moulded body (1, 7, 12, 13) is partially provided with an anti-adhesive coating which prevents adhesion of the metal coating material to the moulded body.

8. The method according to any one of claims 2 to 7, **characterized in that** the moulded body (7, 13) is produced in the injection moulding method whereby at least one carrier part (6, 14) is at least partially overmoulded.

9. Component comprising a moulded body (1, 7, 12, 13) with a coating material (5) which can be produced according to one or more of claims 1 to 8.

10. The component according to claim 9, **characterized in that** the component is an MID component.

11. The component according to claim 9, **characterized in that** the component (6, 7, 8) is a carrier for LED modules (10).

12. The method according to claim 9, **characterized in that** the component comprises the moulded body (12) as carrier and the coating deposited (5) on the moulded body (12) as antenna structure (12).

## Revendications

1. Procédé destiné à fabriquer un corps moulé (1, 7, 12, 13) avec une matière de revêtement (5), comprenant les étapes de procédé
- de la fabrication d'un corps moulé (1, 7, 12, 13) en une matière composite, qui comporte au moins un polymère thermoplastique en tant que matière première (3) et au moins du nitrure de bore en tant qu'une matière de charge (2) anorganique, la part en volume de la matière de charge (2) s'élevant à de 1 à 50 % du volume du corps moulé (1, 7 ,12, 13),
- du revêtement d'une partie du corps moulé (1, 7, 12, 13) avec une matière de revêtement (5) métallique au moyen de plasma atmosphérique.

2. Procédé selon la revendication 1, **caractérisé en ce qu'**on relie le corps moulé de manière adhérente avec au moins une pièce de support.

3. Procédé selon la revendication 1 ou 2, **caractérisé en ce qu'**on fabrique le corps moulé (7, 13) ou l'au moins une pièce de support (6, 14) par procédé de moulage par injection.

4. Procédé selon l'une quelconque des revendications 1 à 3, **caractérisé en ce que** pour la fabrication du corps moulé (1, 7, 12, 13), on utilise exclusivement du nitrure de bore en tant que matière de charge anorganique.

5. Procédé selon l'une quelconque des revendications 1 à 3, **caractérisé en ce que** pour la fabrication du corps moulé (1, 7, 12, 13), on utilise en supplément du nitrure de bore au moins une matière de charge anorganique des classes suivantes de matières de charge:
matières de charge minérales, matières de charge céramiques, matières de charge à base de verre, matières de charge à base carbonée, sulfates, sulfures, matières de charge métalliques ou oydes métalliques.

6. Procédé selon la revendication 5, **caractérisé en ce que** la part en volume du nitrure de bore s'élève à au moins 50 % de la part en volume de la matière de charge.

7. Procédé selon l'une quelconque des revendications 1 à 6, **caractérisé en ce qu'**avant l'étape de procédé du revêtement, on munit partiellement le corps moulé (1, 7, 12, 13) d'un revêtement anti-adhésif qui empêche que la matière de revêtement métallique adhère sur le corps moulé.

8. Procédé selon l'une quelconque des revendications 2 à 7, **caractérisé en ce qu'**on fabrique le corps moulé (7, 13) par procédé de moulage par injection en enrobant par injection au moins en partie l'au moins une pièce de support (6, 14).

9. Composant comprenant un corps moulé (1, 7, 12, 13) avec une matière de revêtement (5), susceptible d'être fabriqué selon l'une quelconque ou plusieurs des revendications 1 à 8.

10. Composant selon la revendication 9, **caractérisé en ce que** le composant est un composant MID.

11. Composant selon la revendication 9, **caractérisé en ce que** le composant (6, 7, 8) est un support pour des modules à DEL (10).

12. Composant selon la revendication 9, **caractérisé en ce que** le composant comporte le corps moulé (12) en tant que support et le revêtement (5) déposé sur le corps moulé (12) en tant que structure d'antenne (12).
